(19) Europäisches Patentamt
European Patent Office
Office européen des brevets

(11) **EP 4 206 822 A1**

(12) **EUROPEAN PATENT APPLICATION**

(43) Date of publication:
**05.07.2023 Bulletin 2023/27**

(21) Application number: **21218004.6**

(22) Date of filing: **28.12.2021**

(51) International Patent Classification (IPC):
**G03F 7/20** (2006.01)    **H01L 21/683** (2006.01)

(52) Cooperative Patent Classification (CPC):
**G03F 7/70708; G03F 7/70525; G03F 7/7085;
H01L 21/6833; H01L 21/68742; H01L 21/6875;
H01L 21/68785**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **REIJNEN, Martinus, Cornelis
5500 AH Veldhoven (NL)**
• **POIESZ, Thomas
5500 AH Veldhoven (NL)**
• **VAN ROOIJ, René, Adrianus
5500 AH Veldhoven (NL)**
• **DRIESSEN, Alexander, Barbara, Jacobus, Maria
5500 AH Veldhoven (NL)**

(74) Representative: **ASML Netherlands B.V.
Corporate Intellectual Property
P.O. Box 324
5500 AH Veldhoven (NL)**

(54) **OBJECT HOLDER, LITHOGRAPHIC APPARATUS COMPRISING SUCH OBJECT HOLDER AND METHODS FOR OBJECT HOLDER**

(57) The invention provides an object holder to hold an object, comprising:
a clamp side to clamp the object, wherein the clamp side is electrically conductive,
at least one electrode arranged at a distance from the clamp side, and electrically isolated from the clamp side, a controller arranged to provide an electrode voltage to the at least one electrode based on a measured charge signal representative for a charge level of the object holder and/or the object in order to decrease a potential difference between an electrical potential of the clamp side and an electrical potential of the object.

**Fig. 2**

**Description**

FIELD

The present invention relates to an object holder. The invention further relates to a lithographic apparatus comprising such object holder and methods to compensate for a charge level of an object and/or an object holder, when the object is being moved towards or from an electrically conductive clamp side of the object holder.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

During the lithographic process a substrate may be supported by a substrate support. The substrate support may be a movable substrate support arranged to accurately position the substrate with respect to a projection system of the lithographic apparatus. To maintain a substrate in a fixed position with respect to the substrate support, the substrate support may comprise electrostatic clamps to clamp the substrate on a support side of the substrate support. The support side of the substrate support may comprise multiple support extensions, such as burls or other supporting structures, defining a support plane on which the substrate is supported.

In known embodiments of a substrate, the backside of the substrate is formed of bare silicon. Due to the bare silicon, the substrate has an electrical connection to the burls of the substrate support when supported on the support side of the substrate support. As a result, the substrate potential becomes equal to burl potential. In other embodiments of the substrate the substrate may be provided with dielectric backside properties, for example by providing a dielectric coating on the backside of the substrate. During (pre-)processing of the substrate, an electrostatic charge can be accumulated at the dielectric coating meaning that the substrate may be charged.

A charged substrate may interact with for example a substrate support. The charge of the substrate creates an electrostatic force towards the support side of the substrate support, especially towards the support extensions, e.g. burls, when the substrate is loaded on the substrate support. Electrostatic force between substrate and substrate support is determined by the electrostatic field in a vacuum gap therebetween. As the substrate is in contact with the burl tops, the gaps, for example due to asperities, from the substrate to the burls are very small. Due to the dielectric backside properties of the substrate, differences in potential between substrate and burls may exist and lead to relatively large electric fields in these gaps. This may cause electrostatic sticking between substrate and burls.

The electrostatic sticking of a substrate on the substrate support may cause several negative effects on substrate clamping performance of the substrate support. During loading of a substrate on the substrate support, a first contact between the charged substrate and the support side, may cause, driven by the substrate charge, an electrostatic force between the substrate and the burls, that results in an increased friction. This increased friction may lead to an increase in substrate load grid. This phenomenon may decrease machine overlay performance. During unloading of the substrate from the support surface, substrate stick at the support side may occur. Also, substrates stick longest at an outer edge of the support side during unload. This may increase edge wear of the support side of the substrate support.

Similar effects may occur when the substrate support, or more generally an object holder, is electrostatically charged. For example, in a substrate support, a clamping unit having one or more electrodes may be provided to clamp the clamping unit on a mirror block and/or or to clamp a substrate on the clamping unit. Such clamping unit may comprise a glass plate placed between the electrodes and the mirror block and/or a glass plate placed between the electrodes and the substrate. These glass plates may also be electrostatically charged and may cause electrostatic sticking between clamping unit and mirror block and/or between clamping unit and substrate.

SUMMARY

It is an object of the invention to provide an object holder that is capable of decreasing one or more of the above-mentioned negative effects of an electrostatically charged object or object holder, for example when loading a charged substrate having dielectric backside properties. Further, it is an object of the invention to provide a method that decreases one or more of the above-mentioned negative effects of an electrostatically charged substrate having dielectric backside properties during loading/unloading a substrate on/from the substrate support.

According to an aspect the invention there is provided an object holder to hold an object, comprising:

    a clamp side to contact the object, wherein the clamp side is electrically conductive,
at least one electrode arranged at a distance from the clamp side, and electrically isolated from the clamp side,
a controller arranged to provide an electrode voltage to the at least one electrode based on a measured charge signal representative for a charge level of the object holder and/or the object in order to decrease a potential difference between an electrical potential of the clamp side and an electrical potential of the object.

According to an aspect the invention there is provided a lithographic apparatus comprising an object holder to hold an object, comprising:

     a clamp side to contact the object, wherein the clamp side is electrically conductive,
at least one electrode arranged at a distance from the clamp side, and electrically isolated from the clamp side,
a controller arranged to provide an electrode voltage to the at least one electrode based on a measured charge signal representative for a charge level of the object holder and/or the object in order to decrease a potential difference between an electrical potential of the clamp side and an electrical potential of the object.

According to an aspect the invention there is provided a method to compensate for a charge level of an object holder or an object when the object is moved towards an electrically conductive clamp side of the object holder, wherein the object holder comprises at least one electrode arranged at a distance from the clamp side, and electrically isolated from the clamp side, the method comprising the steps of:

     moving the object towards the clamp side of the object holder, and
providing an electrode voltage to the at least one electrode based on a measured charge signal representative for a charge level of the object and/or the object holder in order to decrease a potential difference between an electrical potential of the clamp side and an electrical potential of the object.

According to an aspect of the invention, there is provided a method to compensate for a charge level of an object and/or an object holder when the object is being unloaded from an electrically conductive clamp side of the object holder, wherein the object holder comprises at least one electrode arranged at a distance from the clamp side, and electrically isolated from the clamp side, the method comprising the steps of:

     moving the object away from the clamp side of the object holder, and

providing an electrode voltage to the at least one electrode based on a measured charge signal representative for a charge level of the object and/or the object holder in order to decrease a potential difference between an electrical potential of the clamp side and an electrical potential of the object.

BRIEF DESCRIPTION OF THE DRAWINGS

Embodiments of the invention will now be described, by way of example only, with reference to the accompanying schematic drawings, in which:

-   Figure 1 depicts a lithographic system comprising a lithographic apparatus and a radiation source;
-   Figure 2 depicts a substrate support according to a first embodiment of the invention while a substrate is being loaded on the substrate support;
-   Figure 3 depicts schematically the embodiment of Figure 2 in more detail;
-   Figure 4 depicts a substrate support according to a second embodiment of the invention;
-   Figure 5 depicts a substrate support according to a third embodiment of the invention; and
-   Figure 6 depicts a substrate support according to a fourth embodiment of the invention.

DETAILED DESCRIPTION

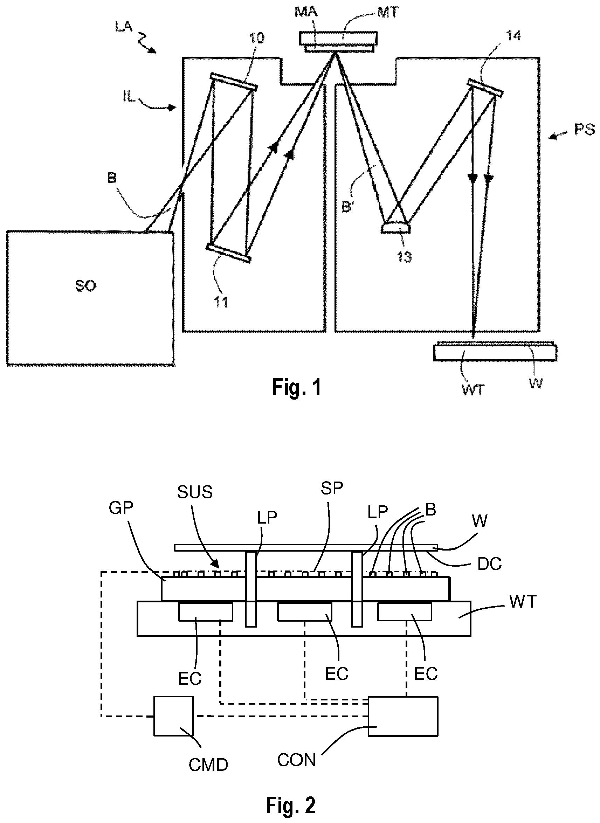

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.
The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.
After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In the lithographic apparatus a movable substrate support WT is used to support the substrate W during the lithographic process.

Figure 2 shows a first embodiment of the substrate support in more detail. The substrate support WT comprises a clamp side to support and clamp a substrate W, also referred to as support side SUS. The support side SUS comprises multiple burls B defining a support plane SP. Instead of the burls B, also other embodiments of support extensions may be provided to define the support plane SP.

The burls B are provided on a glass plate GP. The glass plate GP may for example have a thickness of about 100 $\mu$m and the burls may have a height of about 10 $\mu$m.

Loading pins LP are provided to load a substrate W from a lifted position on the support side SUS of the substrate support WT or to lift the substrate W from the support side SUS of the substrate support WT to a lifted position. The loading pins LP are movable between an extended position in which the loading pins LP extend above the support plane SP, as shown in Figure 2, and a retracted position in which the loading pins LP are completely positioned below the support plane SP. A substrate W may be placed by a substrate handler (not shown) on the loading pins LP when the loading pins LP are in the extended position. The substrate W may be lowered to the support plane SP by moving the loading pins LP to the retracted position. After the lithographic process is finished, the substrate W may be lifted from the support plane SP by moving the loading pins LP from the retracted position to the extended position to allow the substrate handler to take the substrate W from the substrate support WT.

In the substrate support WT, a number of electrodes EC are arranged at a distance from the support side SUS, i.e. at the opposite side of the glass plate GP. The electrodes EC are electrically isolated from the support side SUS. The electrodes EC are part of electrostatic clamps that are used to clamp the substrate W on the support side SUS, i.e. on the top of the burls B, in order to maintain the substrate W in a fixed position with respect to the substrate support during processing of the substrate W. A controller CON is arranged to provide via an electrode signal amplifier ECA an electrode voltage to the one or more electrodes EC in order to create an electrostatic clamping force on the substrate W when positioned on the support side SUS.

Figure 2 shows a substrate W being loaded on the substrate support WT. The substrate W may be provided with dielectric backside properties, for example by providing a dielectric coating DC on the backside of the substrate (the bottom side of the substrate shown in Figure 2). During (pre-)processing of the substrate W, an electrostatic charge can be accumulated at the dielectric coating DC with the result that the substrate W is charged. The charge of the substrate W may create an electrostatic force towards the support side SUS of the substrate support WT. The electrostatic force between the substrate W and support side SUS clamp is determined by the electrostatic field in the vacuum gap therebetween.

When the substrate W is in contact with the tops of the burls B, the gaps, for example due to asperities, from the substrate W to the burls B are very small. When differences in potential between substate W and burls B exist, due to the charged substrate W, electrostatic sticking between substrate W and burls B may occur. This is generally undesirable.

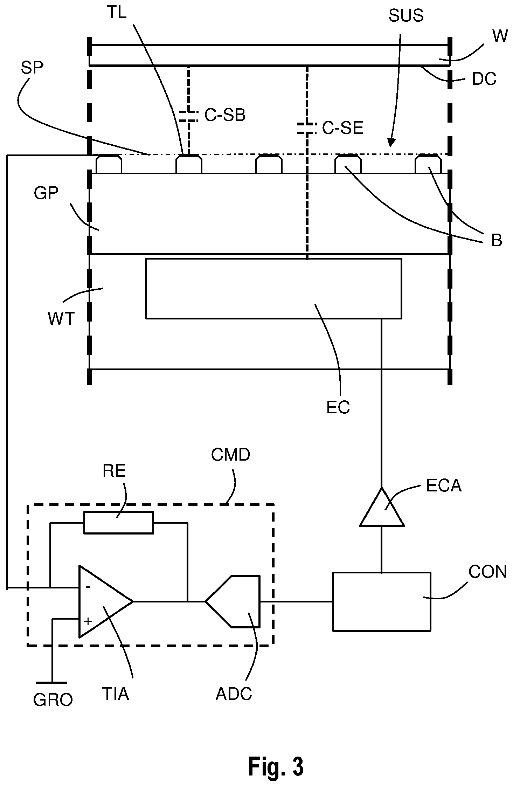

Figure 3 shows in more detail a part of the substrate W being loaded on the substrate support WT. The potential of a charged object, here the substrate W, is defined by its global charge level and the capacitance to the environment. For the substrate W during loading of the substrate W on the substrate support WT, the main capacitances are a first capacitance C-SE from substrate W to electrode(s) EC and a second capacitance C-SB from the substrate W to the tops of the burls B and other support extensions provided on the substrate support WT.

The substrate side SUS is provided with an electrically conducting layer TL that at least covers the tops of the burls B. The layer TL is for example an electrically conductive coating that is provided on or over the burls B and other support extensions provided on the support side SUS of the substrate support WT. During loading and unloading of a substrate W the electrodes EC of the electrostatic clamp act as a single electrode EC. This means that all electrodes EC are provided with the same electrode voltage.

The first capacitance C-SE from substrate to electrode EC has a large surface area which is about equal to the substrate surface, but the distance between the electrodes EC is relatively large. In particular, when the substrate W is placed in the support plane on top of the burls B, the distance between the substrate W and the electrode EC is at least 10 μm vacuum gap plus 100 μm glass plate GP. The second capacitance C-SB from substrate W to burls B has a small surface area. In practice the combined surface area of the stops of the burls B may be about 0.5% of the surface area of the substrate W. But when the substrate W is supported on top of the burls B, the distance between substrate W and the layer TL on top of the burls B is very small. This distance is determined by burl roughness and thickness of wafer backside dielectric, which in practice may be 10 -300 nm.

The result of these dimensional differences is that when the substrate is spaced at a relatively large distance from the support plane SP, such as for example shown in Figure 2, the first capacitance C-SE is dominant, while when the substrate W is at a relatively small distance from the support plane SP, for example when positioned in the support plane SP, the second capacitance C-SB is dominant.

The potential of the substrate W is determined by its charge and its capacitance towards the substrate support WT. Assuming that the substrate W will hold its charge, the substrate potential at a relatively large distance from the support plane SP is determined mainly by the first capacitance C-SE, while the substate potential when the substrate W is at a relatively small distance from the support plane SP is determined mainly by the second capacitance C-SB. This means that during loading of a substrate W where the substrate W is moved from a relatively large distance from the support plane SP to a relatively small distance from the support plane SP the charge moves from the first capacitance C-SE towards the second capacitance C-SB.

As a result of the redistribution of charge in the substrate W caused by movement of the substrate W towards the support plane SP an electrical current is generated in the layer TL of the substrate support WT. This electrical current generated in the layer TL of the support side SUS of the substrate support WT can therefore be used as a charge signal representative for the charge level of the substrate W that is being loaded on the support side SUS of the substrate support WT.

Figures 2 and 3 shows a charge measurement device CMD that can be used to measure the current in the electrically conductive layer TL to determine the charge signal representative for a charge level of the substrate W. The charge measurement device CMD comprises a trans-impedance amplifier TIA, a resistor RE and an analogue to digital convertor ADC. The trans-impedance amplifier TIA comprises a non-inverting input (+) and an inverting input (-). The trans-impedance amplifier TIA creates a potential at the inverting input (-) equal to the potential applied at the non-inverting input (+). Since the non-inverting input (+) is connected to the ground GRO, the inverting input (-) forms a virtual ground connected to the electrically conductive layer TL. As a result, the trans-impedance amplifier TIA will convert an input current to an output voltage. The gain or conversion factor of this conversion from current to voltage is determined by the resistor RE. The output voltage of the trans-impedance amplifier TIA is fed into the analogue to digital convertor ADC that digitizes the output voltage of the trans-impedance amplifier TIA. The output signal of the analogue to digital convertor ADC is used as a charge signal representative for the charge level of the substrate W.

The current that would flow into the amplifier during lowering of the charged substrate is:

$$ I_{C_{sb}} = \frac{V_{wafer}}{\partial C_{sb}} + \frac{\partial V_{wafer}}{C_{sb}} $$

wherein $I_{C_{sb}}$l is the current in the layer TL, $C_{sb}$ is the second capacitance C-SB, $V_{wafer}$ is the potential of the substrate W using burls B as ground reference.

The current through the layer TL that could be captured by the trans-impedance amplifier TIA is thus dependent of substrate voltage and the second capacitance C-SB between the substrate W to the tops of the burls B. If the substrate voltage would be zero, i.e. equal to the voltage in the layer TL, the current flowing into the trans-impedance amplifier TIA will also be zero.

It is noted that as an alternative for contacting the layer TL, also the connection between the one or more electrodes EC and the electrode signal amplifier ECA can be used to determine substrate charge. A similar charge measurement device CMD as shown in Figure 3 can be used to measure the current between the one or more electrodes and electrode signal amplifier ECA to determine a charge signal representative for a charge level of the substrate W. Any other type of charge measurement device or method to determine a charge signal representative for the charge level of the substrate W may also be applied.

The digitized output voltage of the charge measurement device CMD, i.e. the charge signal, as provided by the analogue to digital convertor ADC can be used as input into the controller CON as shown in Figures 2 and 3. The controller CON may use the charge signal to compensate the charge level in the substrate W as follows. IN an alternative embodiment, the charge measurement device CMD and the controller CON may be embodied as analogue devices.

The first capacitance C-SE between substrate W and electrodes EC and the second capacitance C-SB between substrate and burls B form a capacitive circuit, that can be seen as capacitive voltage divider. This means that if the electrode voltage changes, assuming that all electrodes EC in the substrate support WT are used as single electrode during loading and unloading, substrate potential can be manipulated. This means that the actual substrate potential is determined by substrate charge, the first capacitance C-SE, the second capacitance C-SB, and a (common) electrode voltage of the one or more electrodes as follows:

$$V_{wafer} = \frac{Q_{wafer}}{(C_{sb}+C_{se})} + V_{el} * \frac{(C_{sb}+C_{se})}{C_{sb}}$$

wherein $V_{wafer}$ is the substrate potential, $Q_{wafer}$ is the substrate charge level, $C_{se}$ is the first capacitance C-SE, $C_{sb}$ is the second capacitance C-SB, and $V_{el}$ is the electrode voltage.

In an ideal situation, substrate potential is equal to potential at the layer TL at the moment the wafer is loaded onto the support plane SP. The electrode voltage that is provided by the controller CON to the one or more electrodes EC can be used to manipulate the substrate voltage during substrate load. This electrode voltage provided by the controller CON can therefore be based on the charge signal determined by the charge measurement device CMD.

The controller may be a PID controller configured to control the electrode voltage on the basis of the charge signal. The controller CON may control the electrode voltage such that the measured displacement current caused by moving charge from the first capacitance C-SE to the second capacitance C-SB is minimized. As a result, the substrate potential will be controlled towards zero at the moment the substrate W is actually loaded in the support plane SP on the burls B. Substantially no electric field will then be present between the substrate W and the layer TL due to the charged substrate.

It is noted that the voltage at the moment the substrate W is fully loaded on the support side SUS multiplied with the first capacitance C-SE closely matches the initial substrate charge level. In this way the actual substrate charge of the substrate W may be determined.

The invention thus provides a method to compensate for a charge level of the substrate W being loaded on an electrically conductive support side SUS, e.g. layer TL of a support side SUS of the substrate support WT, by providing an electrode voltage to the one or more electrodes based on a measured charge signal representative for a charge level of the substrate W being loaded on the support side SUS in order to decrease a potential difference between an electrical potential of the support side SUS and an electrical potential of the substrate W.

This method provides the advantage that no additional normal forces due to electrostatic interaction between substrate W and burls B occurs during loading of the substrate W on the support side SUS. As a result, substrate load grid impact due to charged substrates is substantially reduced. Furthermore, the voltage profile of the electrode voltage as provided by the controller CON obtained during loading of the substrate W on the support side SUS of the substrate support WT can be used during unloading of the substrate to avoid substrate sticking and edge wear of the support side SUS during this unloading. Moreover, the applied electrode voltage when substrate W is loaded on the substrate support WT is an accurate measure for the actual substrate charge.

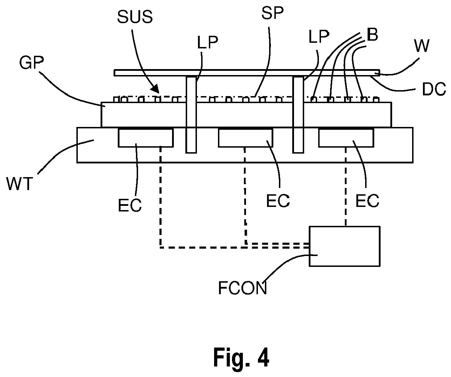

Figure 4 shows a second embodiment of a substrate support WT according to the invention. Figures 2 and 3 show a closed loop PID controller CON that outputs an electrode voltage to the one or more electrodes EC based on a charge signal measured by the charge measurement device CMD. The goal of this feedback loop is to minimize or at least decrease the electrostatic field between the substrate W and the electrically conductive layer TL provided on the burls B during loading and/or unloading of a substrate W on the substrate support WT.

As an alternative for this closed loop control of the electrostatic field between substrate W and the layer TL of the substrate support WT, a feedforward controller FCON can be used to provide an electrode voltage to the one or more electrodes based on a measured charge signal representative for a charge level of the substrate W. The feedforward controller may have a memory to store the electrode signal and/or the charge signal on which the electrode signal is based.

The charge signal may be obtained by measurement of a substrate charge level at another location. For example, before the substrate W is loaded on the substrate support WT, the charge level of the substrate W may be measured at another location or in another way. In an embodiment, the charge level of a substrate W may be measured at another substrate support that support the substrate W before it is loaded on the substrate support WT.

The charge signal may for example be obtained on such other substrate support WT using a similar charge measurement device CMD as shown in Figures 2 and 3 but without direct feedback to the controller CON. In such case, the integrated value of the displacement current caused by the charge moving from the first capacitance C-SE to the second capacitance C-SB may be proportional to the substrate charge. Once the charge signal is known, this charge signal can be used to provide a feedforward signal, in the form of an electrode voltage to the one or more electrodes EC.

The feedforward signal may be a constant value that minimizes the electrostatic field between the substrate W and the electrically conductive layer TL when the substrate W is moved into the support plane SP. Alternatively, the feedforward signal may be an electrode voltage profile that minimizes the electrostatic field between the substrate W and the electrically conductive layer TL during displacement of the substrate W from a lifted position to a supporting position of the substrate W in the support plane. When a voltage profile is used, the electrode signal that is provided by the feedforward controller FCON may be based on a distance between the substrate w and the support side SUS. This distance is for example given by the position of the loading pins LP.

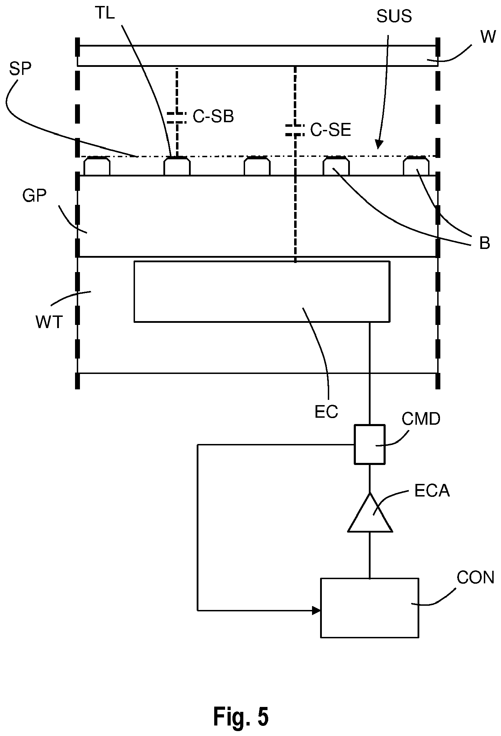

Figure 5 shows a third embodiment of a substrate support WT and a substrate W being loaded on the substrate support WT.

It is possible that the glass plate GP between the electrode EC and the electrically conducting layer TL is electrostatically charged. This may have similar negative effects on loading of the substrate W on the support side SUS as loading of a charged substrate as described with respect to the embodiment of Figures 2 and 3. It is therefore desirable that the potential difference between an electrical potential of the clamp side. e.g. the support side SUS, and an electrical potential of the substrate is decreased when the substrate W is arranged on the support side SUS of the substrate support WT.

To make compensation possible, the substrate W is grounded during the measurements. For example, the bottom side of the substrate W is made electrically conducting and grounded via the loading pins LP. As a result, the substrate W is not electrostatically charged.

When moving the substrate W towards the support side SUS of the substrate support WT, the electrostatic charge in the glass plate GP will be redistributed over the first capacitance C-SE and the second capacitance C-SB. This redistribution of the charge causes an electrical current in the electrodes EC and towards the electrode voltage amplifier ECA. This electrical current generated in the electrodes EC can be used as a charge signal representative for the charge level of the glass plate GP, while the substrate W is being loaded on the support side SUS of the substrate support WT.

A charge measurement device CMD is provided to measure the electrical current from the electrodes EC towards the electrode voltage amplifier ECA to determine the charge signal. The charge measurement device CMD may be embodied as an ampere meter or as shown in Figure 3.

The output voltage of the charge measurement device CMD, i.e. the charge signal, is fed into the controller CON. The controller CON uses the charge signal to compensate the charge level in the glass plate GP. To compensate this charge level, the controller CON will provide a control signal to the electrode(s) that will result in a substantially decreased potential difference between the support side SUS and the substrate W.

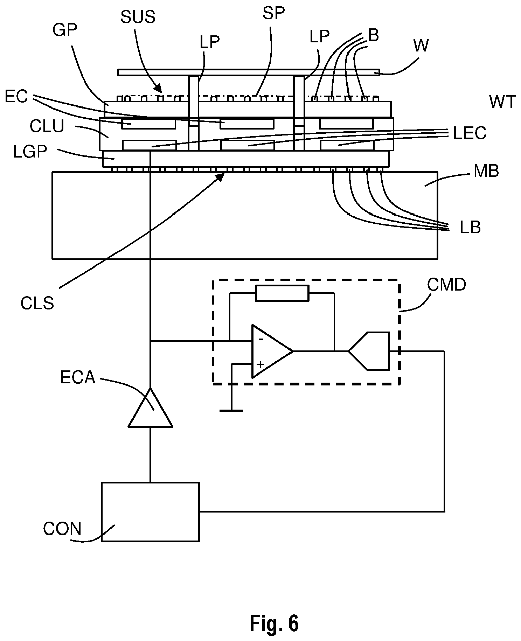

Figure 6 shows a fourth embodiment of a substrate support WT. The substrate support WT comprises a clamping unit CLU comprising electrodes EC to electrostatically clamp the substrate W and a glass plate GP arranged between the electrodes EC comprising burls B to define a support plane SP to support a substrate W placed on the support side SUS of the substrate support WT.

The clamping unit CLU is supported on a mirror block MB. The mirror block MB comprises reflective surfaces that are used to measure a position of the substrate support WT. The clamping unit CLU comprises lower electrodes LEC to clamp the clamping unit CLU on the mirror block MB. A lower glass plate LGP with lower burls LB is arranged between the lower electrodes LEC and the mirror block MB. The lower glass plate LGP and lower burls LB define a lower clamp side CLS of the clamping unit CLU with which the clamping unit CLU is clamped against the mirror block MB.

Normally, the clamping unit CLU is clamped on the mirror block MB, but periodically the clamping unit CLU may be shortly lifted from the mirror block MB for relaxation, a so-called wafer table relaxation. The clamping unit CLU may for example with its clamp side be lifted from the mirror block MB by increased gas pressure between the mirror block MB and the clamping unit CLU, while the lower electrodes LEC do not exert a clamping force on the mirror block MB.

The lower glass plate LGP may be electrostatically charged, while the mirror block MB is grounded. This may have negative effects due to the potential difference between the mirror block MB and the lower glass plate LGP. For example, electrostatic sticking effects may occur when the clamping unit CLU is shortly lifted from the mirror block MB during a wafer table relaxation.

At the same time, the temporarily lifting of the clamping unit CLU from the mirror block MB causes a movement of the mirror block MB with respect to the lower clamp side CLS of the clamping unit CLU. Due to this relative movement between mirror block MB and clamping unit CLU, the electrostatic charge in the lower glass plate LGP is redistributed over a first capacitance between the lower clamp side CLS and the lower electrodes and a second capacitance between the lower clamp side CLS and the mirror block MB. This redistribution of the electrostatic charge in the lower glass plate LGP causes a current from the lower electrodes LEC to the electrode voltage amplifier ECA This current is representative for the electrostatic charge of the lower glass plate LGP and can be measured by a charge measurement device CMD. The charge measurement device CMD may be embodied as the charge measurement device CMD of the embodiment of Figure 5, but may also be any other type of charge measurement device that is capable of measuring this current.

When the electrostatic charge in the lower glass plate LGP is measured, this charge may also be compensated by feeding the measured current into the controller CON that may provide an electrode voltage to the lower electrodes during lifting of the clamping unit CLU from the mirror block MB in order to reduce the potential difference between the lower clamp side CLS and the mirror block MB in order to reduce the negative effects thereof such as electrostatic sticking of the clamping unit CLU on the upper surface of the mirror block MB.

The application of the invention is not limited to the described examples related to a substrate support. The invention may be applied in any object holder for holding an object in which an electrostatic charge of the object or object holder may have negative effects on the positioning of the object on a clamp side of the object holder, and where a redistribution of the charge over two capacitances may be used to determine a charge level of the electrostatic charge. The electrostatic charge may be compensated using a feedback controller or feed forward controller which is configured to decrease a potential difference between an electrical potential of the clamp side and an electrical potential of the object by providing an electrode voltage to the electrode of the object holder.

Although specific reference may be made in this text to the use of lithographic apparatus in the manufacture of ICs or to a semiconductor process apparatus, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Clauses

     1. An object holder to hold an object, comprising:

         a clamp side to clamp the object, wherein the clamp side is electrically conductive,
         at least one electrode arranged at a distance from the clamp side, and electrically isolated from the clamp side,
         a controller arranged to provide an electrode voltage to the at least one electrode based on a measured charge signal representative for a charge level of the object holder and/or the object in order to decrease a potential difference between an electrical potential of the clamp side and an electrical potential of the object.

2. The object holder of clause 1, wherein the object holder comprises a charge measurement device, wherein the charge measurement device is arranged to measure the charge signal representative for the charge level of the object holder and/or the object when the object is moved towards the clamp side.

3. The object holder of clause 2, wherein the charge measurement device is arranged to measure a current through the electrically conductive clamp side and/or the at least one electrode.

4. The object holder of clause 3, wherein the controller is arranged to minimize the current through the electrically conductive clamp side and/or the at least one electrode.

5. The object holder of any of the clauses 2-4, wherein the charge measurement device comprises a trans-impedance amplifier and an analogue to digital convertor, wherein the trans-impedance amplifier comprises a non-inverting input and an inverting input, wherein the non-inverting input is connected to ground and the inverting input is connected to the electrically conductive clamp side or the at least one electrode, and wherein an output of the trans-impedance amplifier is connected to an input of the analogue to digital convertor, wherein an output of the analogue to digital convertor is the charge signal.

6. The object holder of any of the clauses 2-5, wherein the electrically conductive clamp side comprises an electrically conductive layer.

7. The object holder of any of the preceding clauses, wherein the controller is a feedback controller.

8. The object holder of clause 1, wherein the controller is a feedforward controller arranged to provide the electrode voltage to the at least one electrode based on a previously determined charge signal.

9. The object holder of any of the preceding clauses, wherein the at least one electrode is an electrode of an electrostatic clamp for clamping the object on the clamp side.

10. The object holder of any of the preceding clauses, wherein the clamp side comprises multiple support extensions defining a support plane.

11. The object holder of any of the preceding clauses, wherein the object holder comprises multiple loading pins to load the object on the clamp side or to lift the object from the clamp side.

12. The object holder of any of the preceding clauses, wherein the object holder is a substrate support and the object is a substrate.

13. The object holder of any of the clauses 1-12, wherein the object holder is a clamping unit of a substrate support and the object is a mirror block of a substate support.

14. A lithographic apparatus or a semiconductor process apparatus comprising the object holder of any of the preceding clauses.

15. A method to compensate for a charge level of an object holder or an object when the object is moved towards an electrically conductive clamp side of the object holder, wherein the object holder comprises at least one electrode arranged at a distance from the clamp side, and electrically isolated from the clamp side,

the method comprising the steps of:

moving the object towards the clamp side of the object holder, and
providing an electrode voltage to the at least one electrode based on a measured charge signal representative for a charge level of the object and/or the object holder in order to decrease a potential difference between an electrical potential of the clamp side and an electrical potential of the object.

16. The method of clause 15, wherein the method comprises measuring the charge signal, and controlling the electrode voltage to the at least one electrode based on the measured charge signal.

17. The method of clause 16, wherein the step of measuring comprises measuring a current through the electrically conductive clamp side and/or through the at least one electrode.

18. The method of clause 17, wherein controlling the electrode voltage comprises minimizing the current through the electrically conductive clamp side and/or through the at least one electrode.

19. The method of clause 15, wherein the method comprises controlling the electrode voltage to the one or more electrodes on the basis of a feedforward control signal wherein the feedforward control signal is based on a charge signal that is previously determined.

20. A method to compensate for a charge level of an object and/or an object holder when the object is being unloaded from an electrically conductive clamp side of the object holder, wherein the object holder comprises at least one electrode arranged at a distance from the clamp side, and electrically isolated from the clamp side,

the method comprising the steps of:

moving the object away from the clamp side of the object holder, and
providing an electrode voltage to the at least one electrode based on a measured charge signal representative for a charge level of the object and/or the object holder in order to decrease a potential difference between an electrical potential of the clamp side and an electrical potential of the object.

21. The method of clause 20, wherein the measured charge signal is obtained during loading of the object on the object holder.

22. The method of any of the clauses 15-21, wherein the object holder is a substrate support and the object is a substrate.

23. The method of any of the clauses 15-21, wherein the object holder is a clamping unit of a substrate support and the object is a mirror block of a substate support.

**Claims**

1. An object holder to hold an object, comprising:

a clamp side to clamp the object, wherein the clamp side is electrically conductive,
at least one electrode arranged at a distance from the clamp side, and electrically isolated from the clamp side,
a controller arranged to provide an electrode voltage to the at least one electrode based on a measured charge signal representative for a charge level of the object holder and/or the object in order to decrease a potential difference between an electrical potential of the clamp side and an electrical potential of the object.

2. The object holder of claim 1, wherein the object holder comprises a charge measurement device, wherein the charge measurement device is arranged to measure the charge signal representative for the charge level of the object holder and/or the object when the object is moved towards the clamp side.

3. The object holder of claim 2, wherein the charge measurement device is arranged to measure a current through the electrically conductive clamp side and/or the at least one electrode.

4. The object holder of claim 3, wherein the controller is arranged to minimize the current through the electrically conductive clamp side and/or the at least one electrode.

5. The object holder of any of the claims 2-4, wherein the charge measurement device comprises a trans-impedance amplifier and an analogue to digital convertor, wherein the trans-impedance amplifier comprises a non-inverting input and an inverting input, wherein the non-inverting input is connected to ground and the inverting input is connected to the electrically conductive clamp side or the at least one electrode, and wherein an output of the trans-impedance amplifier is connected to an input of the analogue to digital convertor, wherein an output of the analogue to digital convertor is the charge signal.

6. The object holder of any of the claims 2-5, wherein the electrically conductive clamp side comprises an electrically conductive layer.

7. The object holder of claim 1, wherein the controller is a feedback controller or a feedforward controller arranged to provide the electrode voltage to the at least one electrode based on a previously determined charge signal.

8. The object holder of any of the preceding claims, wherein the at least one electrode is an electrode of an electrostatic clamp for clamping the object on the clamp side.

9. The object holder of any of the preceding claims, wherein the clamp side comprises multiple support extensions defining a support plane.

10. The object holder of any of the preceding claims, wherein the object holder comprises multiple loading pins to load the object on the clamp side or to lift the object from the clamp side.

11. The object holder of any of the preceding claims, wherein the object holder is a substrate support and the object is a substrate.

12. The object holder of any of the claims 1-11, wherein the object holder is a clamping unit of a substrate support and the object is a mirror block of a substate support.

13. A lithographic apparatus or a semiconductor process apparatus comprising the object holder of any of the preceding claims.

14. A method to compensate for a charge level of an object holder or an object when the object is moved towards an electrically conductive clamp side of the object holder, wherein the object holder comprises at least one electrode arranged at a distance from the clamp side, and electrically isolated from the clamp side,
the method comprising the steps of:

    moving the object towards the clamp side of the object holder, and
    providing an electrode voltage to the at least one electrode based on a measured charge signal representative for a charge level of the object and/or the object holder in order to decrease a potential difference between an electrical potential of the clamp side and an electrical potential of the object.

15. A method to compensate for a charge level of an object and/or an object holder when the object is being unloaded from an electrically conductive clamp side of the object holder, wherein the object holder comprises at least one electrode arranged at a distance from the clamp side, and electrically isolated from the clamp side,
the method comprising the steps of:

    moving the object away from the clamp side of the object holder, and
    providing an electrode voltage to the at least one electrode based on a measured charge signal representative for a charge level of the object and/or the object holder in order to decrease a potential difference between an electrical potential of the clamp side and an electrical potential of the object.

Fig. 1

Fig. 2

**Fig. 3**

**Fig. 4**

**Fig. 5**

**Fig. 6**

Europäisches
Patentamt

European
Patent Office

Office européen
des brevets

# EUROPEAN SEARCH REPORT

Application Number

**EP 21 21 8004**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2010/284121 A1 (ARUGA YOSHIKI [JP] ET AL) 11 November 2010 (2010-11-11)<br>* abstract *<br>* figures 1,2 *<br>* paragraphs [0001], [0031] – [0042] *<br>----- | 1-15 | INV.<br>G03F7/20<br>H01L21/683 |
| A | WO 2020/229302 A1 (ASML NETHERLANDS BV [NL]) 19 November 2020 (2020-11-19)<br>* abstract *<br>* figures 2,4,10 *<br>* paragraphs [0002], [0022], [0030], [0076], [0079], [0097], [0165] – [0201] *<br>----- | 1-15 | |
| A | US 2008/218931 A1 (HSU YEN-HSIANG [TW] ET AL) 11 September 2008 (2008-09-11)<br>* abstract *<br>* figure 2 *<br>* paragraphs [0001], [0007], [0008], [0013] *<br>----- | 1-15 | |
| A | US 2004/114124 A1 (HOEKS MARTINUS HENDRICUS HENDR [NL] ET AL) 17 June 2004 (2004-06-17)<br>* abstract *<br>* figures 1-4 *<br>* paragraphs [0002], [0014], [0015], [0063] – [0068], [0077], [0078] *<br>----- | 1-15 | **TECHNICAL FIELDS SEARCHED (IPC)**<br><br>G03F<br>H01L |

The present search report has been drawn up for all claims

| Place of search | Date of completion of the search | Examiner |
|---|---|---|
| Munich | 17 June 2022 | Andersen, Ole |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
....................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 21 8004

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2022

| Patent document cited in search report | | Publication date | Patent family member(s) | | Publication date |
|---|---|---|---|---|---|
| US 2010284121 | A1 | 11-11-2010 | CN | 101802998 A | 11-08-2010 |
| | | | JP | 4418032 B2 | 17-02-2010 |
| | | | JP | 2009272646 A | 19-11-2009 |
| | | | JP | WO2009035002 A1 | 24-12-2010 |
| | | | US | 2010096262 A1 | 22-04-2010 |
| | | | US | 2010284121 A1 | 11-11-2010 |
| | | | WO | 2009035002 A1 | 19-03-2009 |
| WO 2020229302 | A1 | 19-11-2020 | CN | 113795912 A | 14-12-2021 |
| | | | EP | 3966634 A1 | 16-03-2022 |
| | | | KR | 20220006536 A | 17-01-2022 |
| | | | TW | 202101659 A | 01-01-2021 |
| | | | WO | 2020229302 A1 | 19-11-2020 |
| US 2008218931 | A1 | 11-09-2008 | CN | 101261927 A | 10-09-2008 |
| | | | US | 2008218931 A1 | 11-09-2008 |
| US 2004114124 | A1 | 17-06-2004 | CN | 1487360 A | 07-04-2004 |
| | | | JP | 2004104114 A | 02-04-2004 |
| | | | KR | 20040030259 A | 09-04-2004 |
| | | | SG | 108323 A1 | 28-01-2005 |
| | | | TW | I240153 B | 21-09-2005 |
| | | | US | 2004114124 A1 | 17-06-2004 |

EPO FORM P0459

For more details about this annex : see Official Journal of the European Patent Office, No. 12/82